# EUROPEAN PATENT APPLICATION

(11) **EP 3 993 571 A1**
(43) Date of publication of application: **04.05.2022**
(21) Application number: 20205341.9
(22) Date of filing: 03.11.2020
(51) Int. Cl.: H05K 1/09, H05K 3/10, H05K 1/02

(54) **VEHICLE ELECTRONICS USING CONDUCTIVE PAINT**

(71) Applicant: Benecke-Kaliko AG, 30419 Hannover (DE)
(72) Inventor: Damodharan, Suchitra - c/o Continental AG, 30419 Hannover (DE)
(74) Representative: Continental Corporation

(57) **Abstract**

A vehicle electronics system (100) is disclosed. The vehicle electronics system (100) includes an electronics control unit (ECU) (104), a vehicle body (218) and painted connections (102). The painted connections (102) are formed from a conductive material in a liquid media, are formed on the vehicle body (218) and transfer data and/or power signals with the ECU (104).

## Description

### FIELD

The field to which the disclosure generally to vehicle electronics and more particularly to vehicle wiring.

### BACKGROUND

This section provides background information to facilitate a better understanding of the various aspects of the disclosure. It should be understood that the statements in this section of this document are to be read in this light, and not as admissions of prior art.

Vehicles of today include complex electronic and computer systems. The electronics control various aspects of the vehicle including engine operation, emissions, braking and the like.

The electronics includes a variety of modules and components. To connect these to each other, a large amount of wiring is needed.

The wiring is generally arranged in bundles of wires that are fished through various parts of the frame. However, these wires add extra weight and/or can be damaged.

One or more techniques are needed to provide electrical communication in vehicles while mitigating the extra weight and susceptability for being damaged.

### BRIEF DESCRIPTION OF THE DRAWINGS

Fig. 1 is a diagram illustrating a vehicle electronic system 100 in accordance with one or more embodiments.
Fig. 2 is a diagram illustrating a section 200 of a vehicle electronic system in accordance with one or more embodiments.
Fig. 3 is a diagram illustrating interconnects 300 in accordance with one or more embodiments.

### DETAILED DESCRIPTION

The following description of the variations is merely illustrative in nature and is in no way intended to limit the scope of the disclosure, its application, or uses. The description is presented herein solely for the purpose of illustrating the various embodiments of the disclosure and should not be construed as a limitation to the scope and applicability of the disclosure. In the summary of the disclosure and this detailed description, each numerical value should be read once as modified by the term "about" (unless already expressly so modified), and then read again as not so modified unless otherwise indicated in context. Also, in the summary of the disclosure and this detailed description, it should be understood that a value range listed or described as being useful, suitable, or the like, is intended that any and every value within the range, including the end points, is to be considered as having been stated. For example, "a range of from 1 to 10" is to be read as indicating each and every possible number along the continuum between about 1 and about 10. Thus, even if specific data points within the range, or even no data points within the range, are explicitly identified or refer to only a few specific, it is to be understood that inventors appreciate and understand that any and all data points within the range are to be considered to have been specified, and that inventors had possession of the entire range and all points within the range.

Unless expressly stated to the contrary, "or" refers to an inclusive or and not to an exclusive or. For example, a condition A or B is satisfied by anyone of the following: A is true (or present) and B is false (or not present), A is false (or not present) and B is true (or present), and both A and B are true (or present).

In addition, use of the "a" or "an" are employed to describe elements and components of the embodiments herein. This is done merely for convenience and to give a general sense of concepts according to the disclosure. This description should be read to include one or at least one and the singular also includes the plural unless otherwise stated.

The terminology and phraseology used herein is for descriptive purposes and should not be construed as limiting in scope. Language such as "including," "comprising," "having," "containing," or "involving," and variations thereof, is intended to be broad and encompass the subject matter listed thereafter, equivalents, and additional subject matter not recited.

Also, as used herein any references to "one embodiment" or "an embodiment" means that a particular element, feature, structure, or characteristic described in connection with the embodiment is included in at least one embodiment. The appearances of the phrase "in one embodiment" in various places in the specification are not necessarily referring to the same embodiment.

The foregoing description of the embodiments has been provided for purposes of illustration and description. Example embodiments are provided so that this disclosure will be sufficiently thorough, and will convey the scope to those who are skilled in the art. Numerous specific details are set forth such as examples of specific components, devices, and methods, to provide a thorough understanding of embodiments of the disclosure, but are not intended to be exhaustive or to limit the disclosure. It will be appreciated that it is within the scope of the disclosure that individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

Also, in some example embodiments, well-known processes, well-known device structures, and well-known technologies are not described in detail. Further, it will be readily apparent to those of skill in the art that in the design, manufacture, and operation of apparatus to achieve that described in the disclosure, variations in apparatus design, construction, condition, erosion of components, gaps between components may present, for example.

Vehicles of today include complex electronic and computer systems. The electronics control various aspects of the vehicle including engine operation, emissions, braking and the like.

The electronics includes a variety of modules and components. To connect these to each other, a large amount of wiring is needed.

The wiring is generally arranged in bundles of wires that are fished through various parts of the frame. However, these wires add extra weight and/or can be damaged.

One or more embodiments are disclosed that provide electrical interconnection reliably and while mitigating extra weight. The connections are made by painting/printing conductive paint and the like directly over different surfaces in the body/frame. The connections can include CAN / LIN / Ethernet printed / painted over the surfaces of the body. Localize certain wiring to certain surface of automotive body Engine ECUs and wiring connections for ECUs in and around engine systems etc. Additionally, a seat sensor can be integrated with conductive paints on fabric.

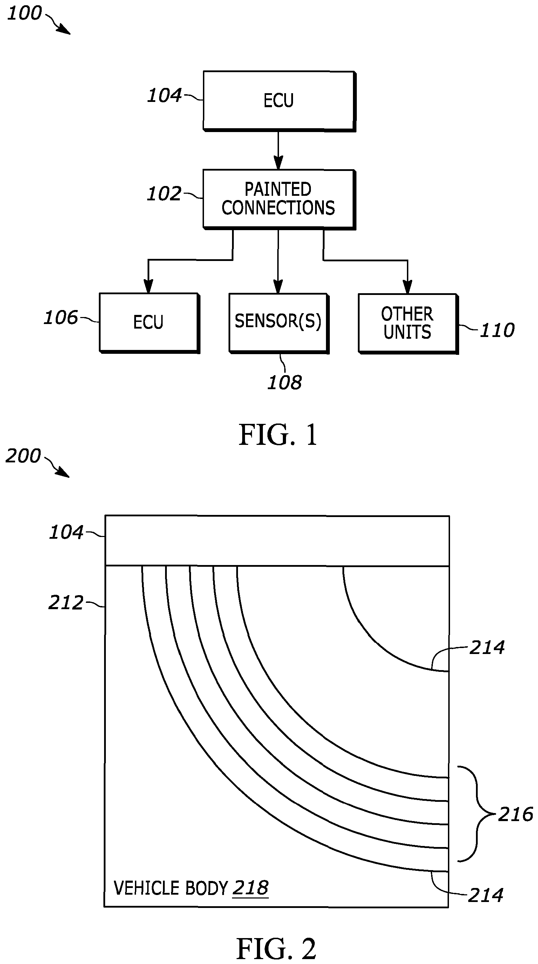

Fig. 1 is a diagram illustrating a vehicle electronic system 100 in accordance with one or more embodiments. It is appreciated that the system 100 is provided for illustrative purposes and that suitable variations are contemplated.

The system 100 is utilized in a vehicle, which generally includes a chassis, frame, drive system, powertrain, wheels and the like.

The system 100 includes an electronic control unit (ECU) 104, painted wiring 102, a second control unit 106, one or more sensors 108 and other units/components 110.

The electronic control unit 104 is an embedded system in automotive electronics that controls one or more of the electrical systems or subsystems in a vehicle.

The ECU 104 can be one of a variety of types such as engine control module (ECM), powertrain control module (PCM), Transmission Control Module (TCM), Brake Control Module (BCM or EBCM), Central Control Module (CCM), Central Timing Module (CTM), General Electronic Module (GEM), Body Control Module (BCM), Suspension Control Module (SCM), control unit, or control module.

The system 100 can also include other units/modules, such as a one or more additional ECUs 106, sensor(s) 108, and/or other units 110. The sensors 108 can include seat sensors, temperature sensors, speed sensors, position sensors, pressure sensors and the like. Additionally, the sensors 108 can be flexible and/or printed circuitry.

Painted connections 102 provide electrical connectivity between the ECU 104 and other units of the system 100.

The painted connections 102 are configured to transfer/transmit power, information, control signals, and the like. The painted connections 102 are applied and/or adhered to a vehicle body.

The painted connections 102 include various materials, such as epoxy, conductive paints, conductive inks, combinations thereof and the like. The term conductive paint can be interpreted to include conductive paint, conductive epoxy, conductive inks and the like.

Conductive epoxy is an epoxy that can conduct electricity. The epoxy includes conductive materials such as graphite or silver to enable conduction.

Conductive paint is a combination of conductive particles, such as metals or graphite, and a liquid medium. The liquid medium typically has a selected color.

Conductive ink is a form of ink that can conduct electricity. Typically, the ink is infused with a conductive material, like graphite or silver, to enable electrical conduction. The ink can be applied to conductive or non-conductive surfaces of the vehicle, such as the vehicle body, dash, console, seats, interior compartment surfaces and the like. The ink can have a selected color.

It is appreciated that metal type conductive material can provide or support higher current than graphite conductive material.

The painted connections 102 can comprise multiple layers of conductive and/or non-conductive paint. For example, a non-conductive or insulating layer can be formed on a vehicle body surface using a standard or non-conductive paint. Individual wires or traces can be formed on the insulating wire using conductive paint. A coating layer can then be formed over the wires or traces to mitigate electrical exposure, damage to the traces, and the like. Additionally, the layers and traces can have selected colors for aesthetic purposes and/or to identify functionality. For example, the insulating layer can be colored white to indicate it is non-conductive. The traces can have metallic colors to indicate their operation as traces/wires.

The connections 102 can include and/or utilize a Controller Area Network (CAN), Controller Area Network Flexible Data-Rate (CAN FD), Local interconnect network (LIN), Ethernet, Ethernet printed, two wire power/data protocols and the like. Localize certain wiring to certain surface of automotive body Engine ECUs and wiring connections for ECUs in and around engine systems etc.

In one example, a seat sensor is integrated into a vehicle seat of the vehicle by using conductive paints on fabric. The seat sensor (not shown) is connected to the ECU 104 using the connections 102 and the ECU 104 is configured to determine occupancy of the vehicle seat based on output from the seat sensor via the connections 102. The ECU 104 can be configured to activate a heating element located in the vehicle seat based on the output from the seat sensor.

Fig. 2 is a diagram illustrating a section 200 of a vehicle electronic system in accordance with one or more embodiments. It is appreciated that the Fig. 2 is provided for illustrative purposes and that suitable variations are contemplated.

The section 200 includes a vehicle body 212 with painted connections 102 formed thereon.

In this example, the painted connections 102 are formed on a surface of the vehicle body.

An insulative layer 214 bound by the shown edges can be formed on the surface.

A plurality of wires or traces 216 are formed on the insulative layer 214. The wires 216 provide a signal and/or power transmission/reception path between various elements/components.

In this example, the connections 102 are connected to the ECU 104.

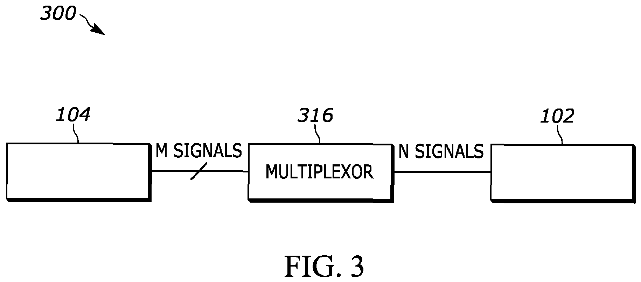

Fig. 3 is a diagram illustrating interconnects 300 in accordance with one or more embodiments. It is appreciated that the interconnects 300 are provided for illustrative purposes and that suitable variations are contemplated.

The interconnects 300 show an example of connections through painted connections 102.

It is appreciated that the painted connections 102 may a lower capacity for individual wires compared with typical conductive wiring using cables. Thus, a multiplexor/demultiplexor 316 can be used to facilitate carrying additional data/power signals with the painted connections 102

In this example, the ECU 104 has a plurality of inputs and outputs. These include ground, DC power, control inputs/outputs, data inputs/outputs and the like. The number of inputs/outputs and corresponding signals can vary from the number of distinct connections provided by the painted connections 102.

In this example, the ECU has M inputs/outputs or signals while the painted connection 102 has N signal connections, paths or traces. For example, the painted connection 102 can include N distinct traces formed from conductive paint.

In one example, the N traces are formed on an insulative layer. In another example, the N traces are separated by insulative or non-conductive paint.

A multiplexor/demultiplexor 316 is configured to multiplex the M signals from the ECU 104 to the N signals for the painted connections 102. Additionally, the multiplexor/demultiplexor 316 is configured to demultiplex/multiplex the N signals from the painted connections 102 to the M signals for the ECU 104.

The N signals are carried by the painted connections 102 to another component such as a sensor, seat sensor, ECU and the like. An additional multiplexor/demultiplexor (not shown) can be used to multiplex/demultiplex the N signals into the M signals.

It is noted that 'having' does not exclude other elements or steps and 'one' or 'one' does not exclude a multitude. It should also be noted that characteristics described with reference to one of the above examples of execution can also be used in combination with other characteristics of other examples of execution described above. Reference signs in the claims are not to be regarded as a restriction.

Spatially relative terms, such as "inner", "adjacent", "outer," "beneath," "below," "lower," "above," "upper," and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

One general aspect includes a vehicle electronics system. The vehicle electronics system includes an electronics control unit (ECU), a vehicle body and painted connections. The painted connections are formed from a conductive material in a liquid media, are formed on the vehicle body and provide data and/or power signals to the ecu.

Implementations may include one or more of the following features. The system where the painted connections are formed on a cab interior surface of the vehicle body. The system may include a heating element located in a seat within a cab interior and the heating element is connected to the ECU by the painted connections. The painted connections may include a conductive paint adhered to a surface of the vehicle body. The conductive element is graphite and the media is paint having a selected color. The painted connections are formed on a fabric of the vehicle body. The painted connections may include one or more insulative layers formed on a surface of the vehicle and a plurality of traces formed on the one or more insulative layers, the traces may include conductive paint. The ECU uses M signals and the painted connections carry N signals, where N is less than M. The system further may include a multiplexor configured to convert the M signals into N multiplexed signals. The system may include a plurality of sensors connected to the ECU by the painted connections. The plurality of sensors include a seat sensor and a pressure sensor. The system may include one or more additional ecus connected to the ecu by the painted connections. The ecu is one of an engine control module (ECM), a powertrain control module (PCM), a transmission control module (TCM), a brake control module (BCM or EBCM), a central control module (CCM), a central timing module (CTM), a general electronic module (GEM), a body control module (BCM), and a suspension control module (SCM). The conductive material is metal. The painted connections utilize two wire power/data protocols to transfer power and data using only two traces.

Although a few embodiments of the disclosure have been described in detail above, those of ordinary skill in the art will readily appreciate that many modifications are possible without materially departing from the teachings of this disclosure. Accordingly, such modifications are intended to be included within the scope of this disclosure as defined in the claims.

## Claims

1. A vehicle electronics system (100) comprising:
an electronics control unit (ECU) (104);
a vehicle body (218); and
painted connections (102);
wherein the painted connections are formed from a conductive material in a liquid media, formed on the vehicle body (218), connect to the ECU (104) and transfer data and/or power signals.

2. The system of claim 1, wherein the painted connections (102) are formed on a cab interior surface of the vehicle body (218).

3. The system of claim 2, further comprising a heating element located in a seat within a cab interior and the heating element is connected to the ECU (104) by the painted connections (102).

4. The system of claim 1, wherein the painted connections (102) comprise a conductive paint adhered to a surface of the vehicle body (218).

5. The system of any one of claim 1, wherein the conductive element is graphite and the media is paint having a selected color.

6. The system of claim 1, wherein the painted connections (102) are formed on a fabric of the vehicle body (218).

7. The system of claim 1, wherein the painted connections (102) comprise one or more insulative layers formed on a surface of the vehicle and a plurality of traces (216) formed on the one or more insulative layers, the traces comprising conductive paint.

8. The system of any one of claims 1-7, wherein the ECU (104) uses M signals and the painted connections (102) carry N signals, where N is less than M and the system further comprises a multiplexor (316) configured to convert the M signals into N multiplexed signals.

9. The system of any one of claims 1-7, further comprising a plurality of sensors (108) connected to the ECU (104) by the painted connections (102).

10. The system of any one of claims 1-7, wherein the plurality of sensors (108) include a seat sensor and a pressure sensor.

11. The system of any one of claims 1-7, further comprising one or more additional ECUs (106) connected to the ECU by the painted connections (102).

12. The system of any one of claims 1-7, wherein the ECU (104) is one of an engine control module (ECM), a powertrain control module (PCM), a Transmission Control Module (TCM), a Brake Control Module (BCM or EBCM), a Central Control Module (CCM), a Central Timing Module (CTM), a General Electronic Module (GEM), a Body Control Module (BCM), and a Suspension Control Module (SCM).

13. The system of any one of claims 1-7, wherein the conductive material is metal.

14. The system of any one of claims 1-7, wherein the painted connections (102) utilize two wire power/data protocols to transfer power and data using only two traces.

15. The system of any one of claims 1-7, wherein the painted connections (102) utilize Controller Area Network (CAN) protocols for transferring data and/or power signals.
